# EUROPEAN PATENT APPLICATION

(11) **EP 4 826 601 A1**
(43) Date of publication of application: **21.10.2026**
(21) Application number: 26172164.1
(22) Date of filing: 14.04.2026
(51) Int. Cl.: G06N 10/40

(54) **QUANTUM DEVICE AND METHOD OF MANUFACTURING QUANTUM DEVICE**

(30) Priority: 17.04.2025 JP 2025068411
(71) Applicant: FUJITSU LIMITED, Kawasaki-shi, Kanagawa 211-8588 (JP)
(72) Inventor: ZHOU, Yu, Kawasaki-shi, 211-8588 (JP); KONDO, Daiyu, Kawasaki-shi, 211-8588 (JP)
(74) Representative: Haseltine Lake Kempner LLP

(57) **Abstract**

A quantum device includes a first substrate; a second substrate; and a third substrate. The first substrate includes a first opening; a second opening; and a first quantum circuit pattern which may include a first quantum bit. The second substrate includes a second quantum circuit pattern including a second quantum bit. The third substrate includes a third quantum circuit pattern including a third quantum bit. The second substrate is arranged so as to overlap at least a part of the first opening in plan view. The third substrate is arranged so as to overlap at least a part of the second opening in plan view. The first quantum circuit pattern and the second quantum circuit pattern are coupled. The first quantum circuit pattern and the third quantum circuit pattern are coupled.

## Description

### FIELD

The present disclosure relates to a quantum device and a method of manufacturing a quantum device.

### BACKGROUND

A quantum device having a substrate on which a quantum circuit including a plurality of quantum bits is formed, is proposed. To perform complex quantum operations, a large number of quantum bits are required.
Patent Document 1: Japanese Laid-open Patent Publication No. 2023-79789
Patent Document 2: International Publication Pamphlet No. WO 2018/212041
Patent Document 3: U.S. Patent Application Publication No. 2020/0401924
Patent Document 4: U.S. Patent No. 11493714

### SUMMARY OF INVENTION

### TECHNICAL PROBLEM

However, in a conventional quantum device, when a large substrate is used to provide a large number of quantum bits, the eigenmode frequency of the substrate decreases. The decrease in the eigenmode frequency makes the quantum circuit susceptible to the influence of a resonance mode of an unnecessary frequency, and the reliability of the quantum operation decreases.

An object of the present disclosure is to provide a quantum device capable of suppressing the influence of the decrease in the eigenmode frequency, and a method of manufacturing the quantum device.

### SUMMARY

According to one aspect of the present disclosure, there is provided a quantum device including a first substrate; a second substrate; and a third substrate. The first substrate includes a first opening; a second opening; and a first quantum circuit pattern which may include a first quantum bit. The second substrate includes a second quantum circuit pattern including a second quantum bit. The third substrate includes a third quantum circuit pattern including a third quantum bit. The second substrate is arranged so as to overlap at least a part of the first opening in plan view. The third substrate is arranged so as to overlap at least a part of the second opening in plan view. The first quantum circuit pattern and the second quantum circuit pattern are coupled. The first quantum circuit pattern and the third quantum circuit pattern are coupled.

### ADVANTAGEOUS EFFECTS OF INVENTION

According to the present disclosure, it is possible to suppress the influence of the reduction of the eigenmode frequency.

### BRIEF DESCRIPTION OF THE DRAWINGS

FIG. 1 is a top view illustrating a quantum device according to a first embodiment;
FIG. 2 is a cross-sectional view (part 1) illustrating a quantum device according to a first embodiment;
FIG. 3 is a cross-sectional view (part 2) illustrating a quantum device according to a first embodiment;
FIG. 4 is a cross-sectional view illustrating a through-hole;
FIG. 5 is a top view illustrating a second substrate according to a first embodiment;
FIG. 6 is a top view illustrating two adjacent second substrates according to a first embodiment;
FIG. 7 is a top view illustrating the coupling between a first substrate and a second substrate according to a first embodiment;
FIG. 8 is a cross-sectional view (part 1) illustrating a method of manufacturing a quantum device according to the first embodiment;
FIG. 9 is a cross-sectional view (part 2) illustrating a method of manufacturing a quantum device according to the first embodiment;
FIG. 10 is a cross-sectional view (part 3) illustrating a method of manufacturing a quantum device according to the first embodiment;
FIG. 11 is a cross-sectional view (part 1) illustrating a method of manufacturing a first substrate;
FIG. 12 is a cross-sectional view (part 2) illustrating a method of manufacturing a first substrate;
FIG. 13 is a cross-sectional view (part 3) illustrating a method of manufacturing a first substrate;
FIG. 14 is a cross-sectional view (part 4) illustrating a method of manufacturing a first substrate;
FIG. 15 is a cross-sectional view (part 5) illustrating a method of manufacturing a first substrate;
FIG. 16 is a top view illustrating a second substrate in the second embodiment;
FIG. 17 is a cross-sectional view illustrating a quantum device according to the third embodiment; and
FIG. 18 is a cross-sectional view illustrating a quantum device according to the fourth embodiment.

### DESCRIPTION OF EMBODIMENTS

Hereinafter, embodiments of the present disclosure will be specifically described with reference to the accompanying drawings. Note that in the specification and the drawings, components having substantially the same functional configuration are denoted by the same reference numerals, thereby omitting redundant descriptions.

### (First Embodiment)

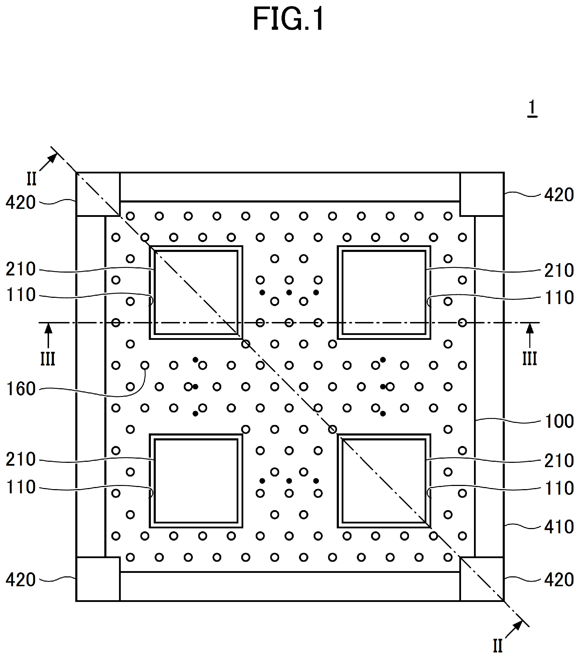

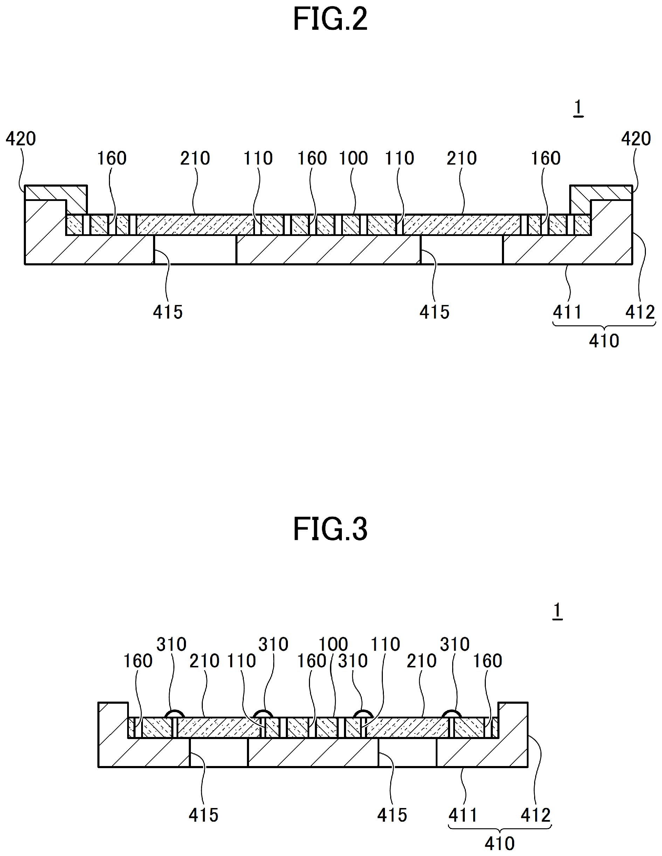

A first embodiment will be described. The first embodiment relates to a quantum device. FIG. 1 is a top view illustrating a quantum device according to the first embodiment. FIGS. 2 and 3 are cross-sectional views illustrating a quantum device according to a first embodiment. FIG. 2 corresponds to a cross-sectional view taken along line II-II in FIG. 1. FIG. 3 corresponds to a cross-sectional view taken along line III-III in FIG. 1.

As illustrated in FIGS. 1 to 3, a quantum device 1 according to a first embodiment includes a first substrate 100, a second substrate 210, a case 410, and a fixing member 420. An opening 110 is formed in the first substrate 100. A plurality of openings 110 may be formed in the first substrate 100. The second substrate 210 is provided inside the opening 110. The outer shape of the first substrate 100 is, for example, rectangular in plan view. For example, the opening 110 and the second substrate 210 each have a rectangular planar shape. The case 410 has a bottom portion 411 and a wall portion 412. For example, the bottom portion 411 has a rectangular planar shape, and the wall portion 412 extends upward from the edge of the bottom portion 411 and has a frame-like shape. The first substrate 100 is housed inside the wall portion 412 on the bottom portion 411. The opening 110 is an example of the first opening and the second opening.

The fixing member 420 contacts the first substrate 100 and fixes the first substrate 100 to the case 410. The fixing member 420 contacts, for example, four corners of the first substrate 100 in plan view. The fixing member 420 is attached to the wall portion 412 by, for example, a screw. The fixing member 420 includes, for example, oxygen-free copper. The fixing member 420 may be formed of oxygen-free copper. The thickness of the fixing member 420 is, for example, 0.6 mm to 0.7 mm. The same number of openings 415 as the opening 110 and the second substrate 210 are formed in the bottom portion 411. The openings 415 are formed below the second substrate 210 and are located inside the contour of the second substrate 210 in plan view. For example, the first substrate 100 has a silicon substrate, and the second substrate 210 has a silicon substrate or a sapphire substrate. The openings 415 are examples of the third and fourth openings.

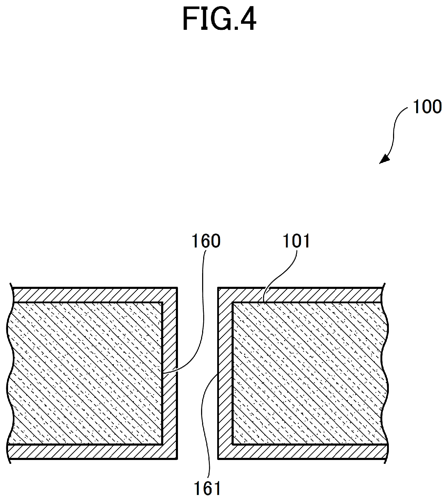

For example, the first substrate 100 has a silicon substrate 101, and a plurality of through-holes 160 which are formed in the silicon substrate 101. The area of each of the plurality of through-hole 160 is smaller than the area of the opening 110. FIG. 4 is a cross-sectional view illustrating a through-hole 160. The quantum device 1 has a conductive layer 161 provided on the wall surface of the through-holes 160 and on both the upper and lower surfaces of the silicon substrate 101. The conductive layer 161 includes, for example, an Al layer or a TiN layer. In FIGS. 1 to 3, the conductive layer 161 is omitted.

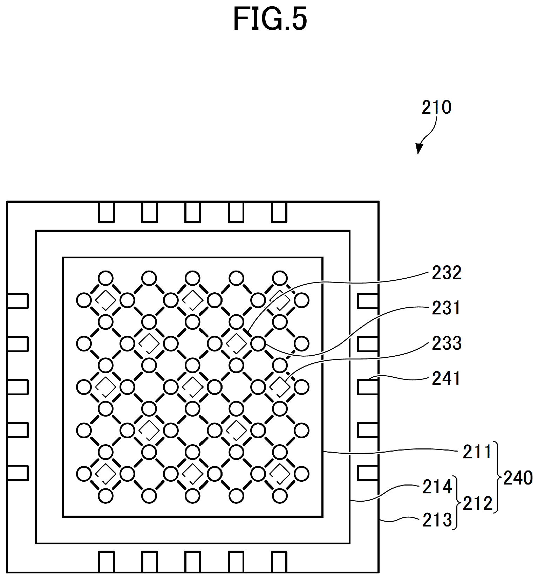

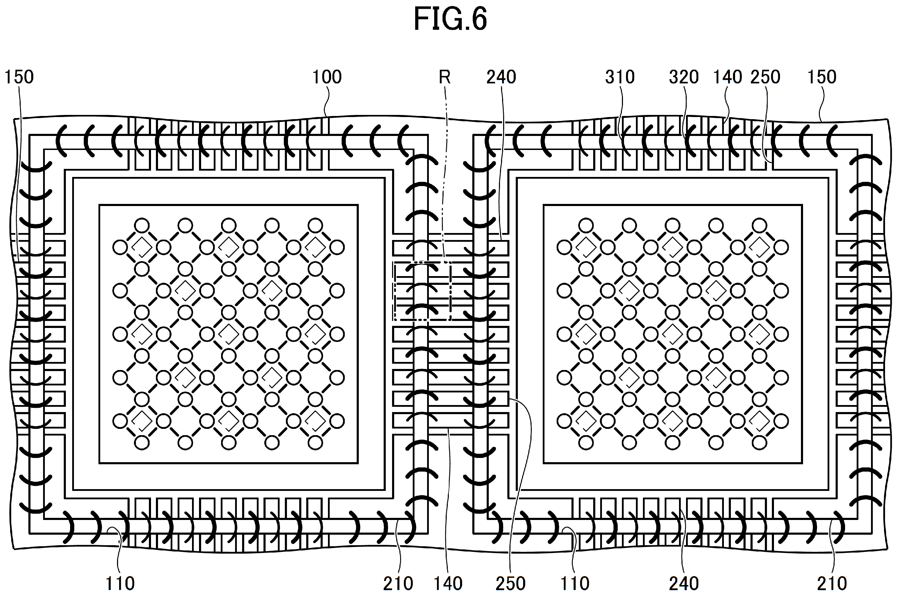

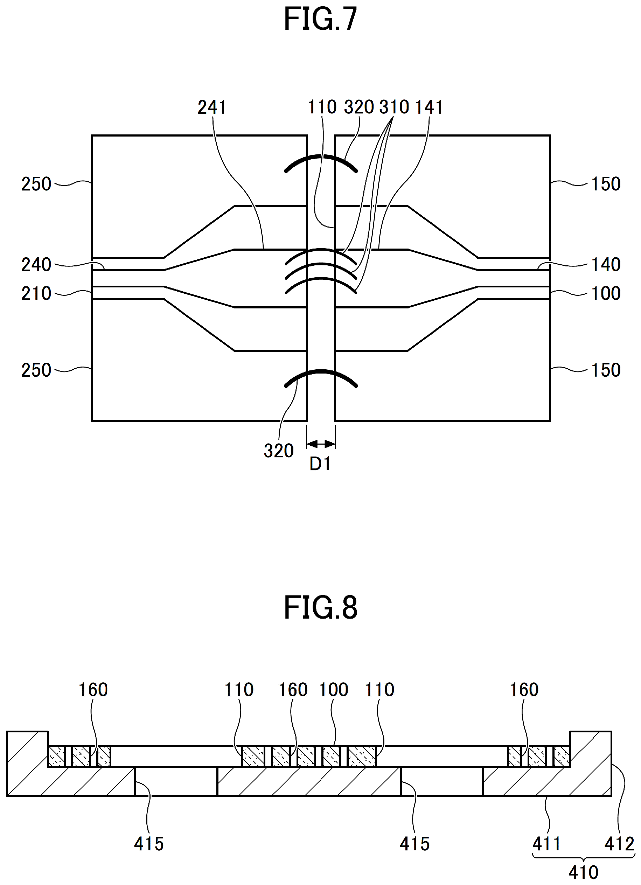

Here, coupling between the first substrate 100 and the second substrate 210 will be described. FIG. 5 is a top view illustrating the second substrate 210 in the first embodiment. FIG. 6 is a top view illustrating two adjacent second substrates 210 in the first embodiment. FIG. 7 is a top view illustrating coupling between the first substrate 100 and the second substrate 210 in the first embodiment. FIG. 7 corresponds to an enlarged view of the region R in FIG. 6.

As illustrated in FIGS. 6 and 7, the first substrate 100 has a first quantum circuit pattern 140 and a first ground pattern 150 on its top surface. The first ground pattern 150 includes a conductive layer 161. The first ground pattern 150 is provided around the first quantum circuit pattern 140. The first quantum circuit pattern 140 has a plurality of first signal pads 141. The first signal pads 141 are close to the openings 110. The first quantum circuit pattern 140 may include a first quantum bit. In addition to the first signal pads 141, the first quantum circuit pattern 140 may include quantum circuits such as a transmission line, a resonator, a filter, and a coupling capacitor. For example, the transmission line includes a configuration of a coplanar waveguide. In FIGS. 1 to 3, the first quantum circuit pattern 140 and the first ground pattern 150 are omitted. The first signal pads 141 are examples of the first signal pad and the second signal pad.

As illustrated in FIGS. 5 to 7, the second substrate 210 has a second quantum circuit pattern 240 on its upper surface, and the second quantum circuit pattern 240 has a core portion 211 and a peripheral portion 212 provided around the core portion 211. In FIGS. 1 to 3, the second quantum circuit pattern 240 is omitted. The second substrate 210 is an example of the second substrate and the third substrate. The second quantum circuit pattern 240 is an example of the second quantum circuit pattern and the third quantum circuit pattern.

The core portion 211 has a plurality of quantum bits 231, a plurality of couplers 232, and a plurality of resonators 233. The number of the quantum bits 231 in the core portion 211 is, for example, 60. The coupler 232 couples two adjacent quantum bits 231. The resonator 233 is provided for every four quantum bits 231, for example. The quantum bit 231, for example, includes a Josephson junction. The quantum bit 231 is an example of a second quantum bit and a third quantum bit.

The peripheral portion 212 has a pad region 213 and a coupler region 214. The second quantum circuit pattern 240 has a plurality of second signal pads 241 in the pad region 213. The second signal pads 241 are close to the edge of the second substrate 210. The second quantum circuit pattern 240 can have a quantum circuit such as a coupler coupling the core portion 211 and the second signal pad 241 in the coupler region 214. The second signal pad 241 is an example of the third signal pad and the fourth signal pad.

The quantum device 1 has a plurality of bonding wires 310 and a plurality of conductive ribbons 320. The bonding wires 310 are connected to the first signal pad 141 and the second signal pad 241, and couple the first signal pad 141 and the second signal pad 241. Impedance is matched between the first signal pad 141 and the second signal pad 241 connected by the bonding wire 310. Pairs of the first signal pad 141 and the second signal pad 241 may be connected by a plurality of bonding wires 310. A conductive ribbon 320 is connected to the first ground pattern 150 and the second ground pattern 250, and couples the first ground pattern 150 and the second ground pattern 250. The second ground pattern 250 is provided around the second quantum circuit pattern 240. Pairs of the first ground pattern 150 and the second ground pattern 250 may be connected by a plurality of conductive ribbons 320. For example, the bonding wire 310 is an Al wire, and the conductive ribbon 320 is an Al ribbon. The bonding wire 310 is an example of the first conductive member and the second conductive member. The conductive ribbon 320 is an example of the third conductive member and the fourth conductive member. The second ground pattern 250 is an example of the second ground pattern and the third ground pattern. In FIG. 1, the bonding wire 310 and the conductive ribbon 320 are omitted.

For example, the second quantum circuit patterns 240 of two adjacent second substrates 210 are coupled to each other via the bonding wire 310 and the first quantum circuit pattern 140.

In the quantum device 1, the second substrate 210 including the quantum bits 231 is provided inside the opening 110 of the first substrate 100. Therefore, by using a plurality of openings 110 and the second substrate 210, a large number of quantum bits 231 can be used without enlarging the second substrate 210. Therefore, a decrease in the eigenmode frequency of the second substrate 210 can be suppressed. Although the second substrate 210 including the quantum bits 231 is provided inside the opening 110 of the first substrate 100 in the present embodiment, the second substrate 210 may be larger than the opening 110 in plan view, and the outer periphery of the second substrate 210 may overlap the first substrate 100 (the edge of the opening 110). Even in this case, because the opening 110 is provided below the central portion of the second substrate, a decrease in the eigenmode frequency can be suppressed. Further, because the through hole 160 is formed in the first substrate 100, a decrease in the eigenmode frequency of the first substrate 100 can be suppressed.

For example, the second substrates 210 can be formed by forming regions to be a plurality of second substrates 210 on one large-sized substrate, for example, a substrate having a diameter of approximately 50 mm to 100 mm, and dividing the substrate into individual pieces. In this case, because only the good second substrate 210 can be included in the quantum device 1, a high yield of the quantum device 1 can be obtained.

The configuration of the second quantum circuit pattern 240 may be different among the plurality of second substrates 210 included in the quantum device 1. Further, the materials of the substrates may be different among the plurality of second substrates 210 included in the quantum device 1. For example, one or more of the second substrates 210 may have a silicon substrate, and the other one or more of the second substrates 210 may have a sapphire substrate.

Because no through hole is formed in the second substrate 210, it is easy to obtain high uniformity of the Josephson junction included in the quantum bit 231. Further, because the second substrate 210 does not have a metal film on its lower surface, it can suppress a decrease in the eigenmode frequency of the second substrate 210.

The second substrate 210 preferably has a rectangular planar shape having a side length of 15 mm or less. This is because it is particularly easy to suppress a decrease in the eigenmode frequency of the second substrate 210. The second substrate 210 more preferably has a rectangular planar shape having a side length of 10 mm or less.

The distance D1 between the wall surface of the opening 110 and the wall surface of the second substrate 210 is preferably 100 µm or less. This is to avoid excessive lengthening of the bonding wire 310 and the conductive ribbon 320. The distance D1 is more preferably is 80 µm or less.

The length of the bonding wire 310 is preferably 400 µm or less. This is to suppress deterioration of a signal transmitted through the bonding wire 310. More preferably, the length of the bonding wire 310 is 300 µm or less.

Preferably, each of the bonding wire 310 and the conductive ribbon 320 has a length longer than the distance D1. This is to provide an allowance for thermal contraction when the temperature of the quantum device 1 is cooled from room temperature to a cryogenic temperature.

Because the opening 415 is formed, a decrease in the eigenmode frequency can be suppressed. According to a simulation performed by the present inventor, the eigenmode frequency is approximately 16 GHz in a silicon chip of 10 mm×10 mm. This eigenmode frequency is sufficiently high with respect to the resonance frequency of the quantum bit (for example, 8 GHz to 9 GHz) and is designed not to affect the resonance frequency.

Further, because the fixing member 420 contains oxygen-free copper, high thermal conductivity is obtained in the fixing member 420. A gold plating film or an aluminum film may be formed on the surface of the fixing member 420. For example, the thickness of the fixing member 420 on the wall portion 412 is 1 mm or less. The fixing member 420 has, for example, a first portion positioned on the wall portion 412 and a second portion extending from the first portion toward the first substrate 100. At a stage before fixing, the sum of the thickness of the first substrate 100 and the length of the second portion of the fixing member 420 is preferably greater than or equal to the sum of the height H from the upper surface of the bottom portion 411 to the upper surface of the wall portion 412 and 0.05 mm, and less than or equal to the sum of the height H and 0.10 mm. When such a relationship is satisfied, the first substrate 100 can be more appropriately fixed to the case 410.

Next, a method of manufacturing the quantum device 1 according to the first embodiment will be described. FIGS. 8 to 10 are cross-sectional views illustrating a method of manufacturing the quantum device 1 according to the first embodiment.

First, as illustrated in FIG. 8, the first substrate 100 is accommodated in the case 410. At this time, the opening 415 of the case 410 is positioned inside the contour of the opening 110.

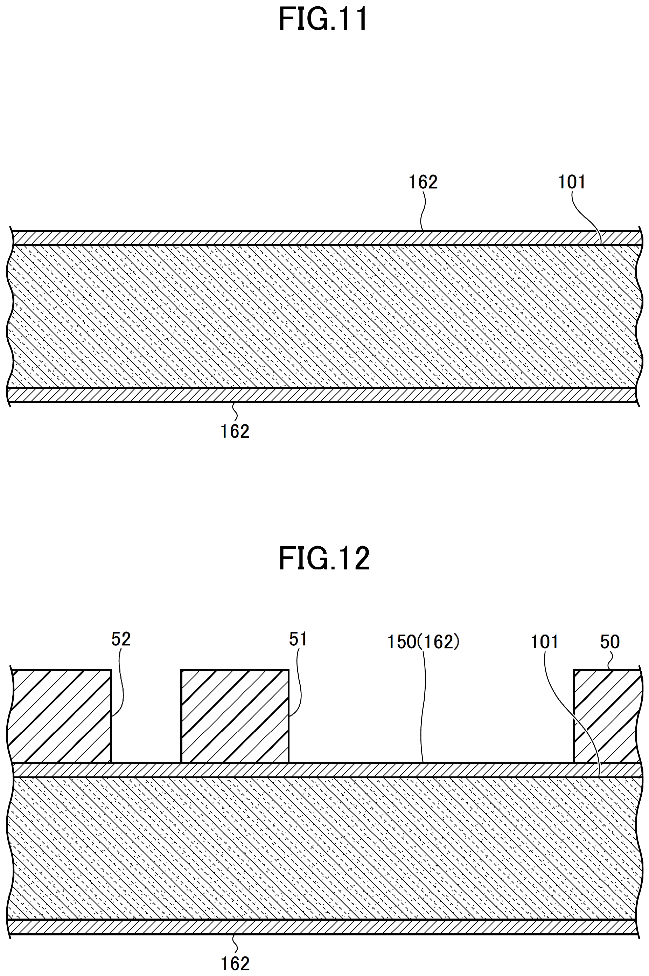

A method of manufacturing the first substrate 100 will now be described. FIGS. 11 to 15 are cross-sectional views illustrating a method of manufacturing the first substrate 100. FIGS. 11 to 15 illustrate cross sections in which the first ground pattern 150 is formed.

In the method of manufacturing the first substrate 100, as illustrated in FIG. 11, a silicon substrate 101 is prepared, and a conductive layer 162 is formed on the upper and lower surfaces of the silicon substrate 101. The conductive layer 162 becomes a part of the conductive layer 161 of the first substrate 100.

Then, the conductive layer 162 is etched by using a mask (not illustrated) to form the first quantum circuit pattern 140 and the first ground pattern 150 on the conductive layer 162. As the etching, for example, reactive ion etching (RIE) is performed.

Next, as illustrated in FIG. 12, a mask 50 is formed on the conductive layer 162 on the upper surface side of the silicon substrate 101. The mask 50 has an opening 51 in a region where the opening 51 is to be formed, and an opening 52 in a region where the through hole 160 is to be formed. The mask 50 can be formed by a photolithography technique.

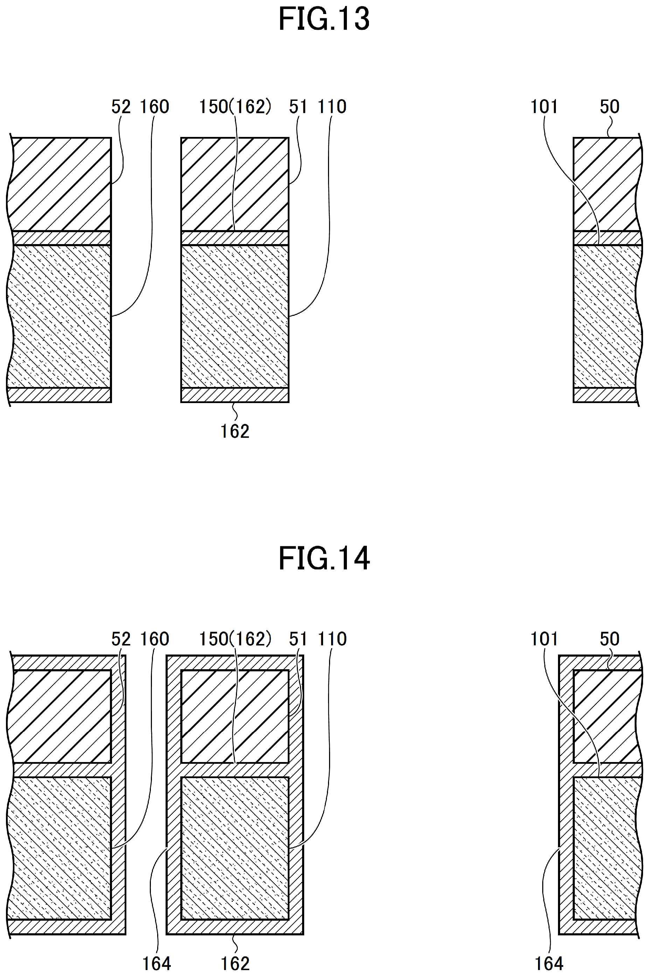

Then, as illustrated in FIG. 13, the conductive layer 162 and the silicon substrate 101 are etched through the openings 51 and 52. As a result, the opening 110 and the through hole 160 are formed in the silicon substrate 101. As the etching, for example, deep reactive ion etching (DRIE) is performed.

Subsequently, as illustrated in FIG. 14, a conductive layer 164 is formed on the surface of the mask 50, the wall surface of the opening 110, and the wall surface of the through hole 160. The conductive layer 164 becomes a part of the conductive layer 161 of the first substrate 100. The conductive layer 164 continues to the conductive layer 162.

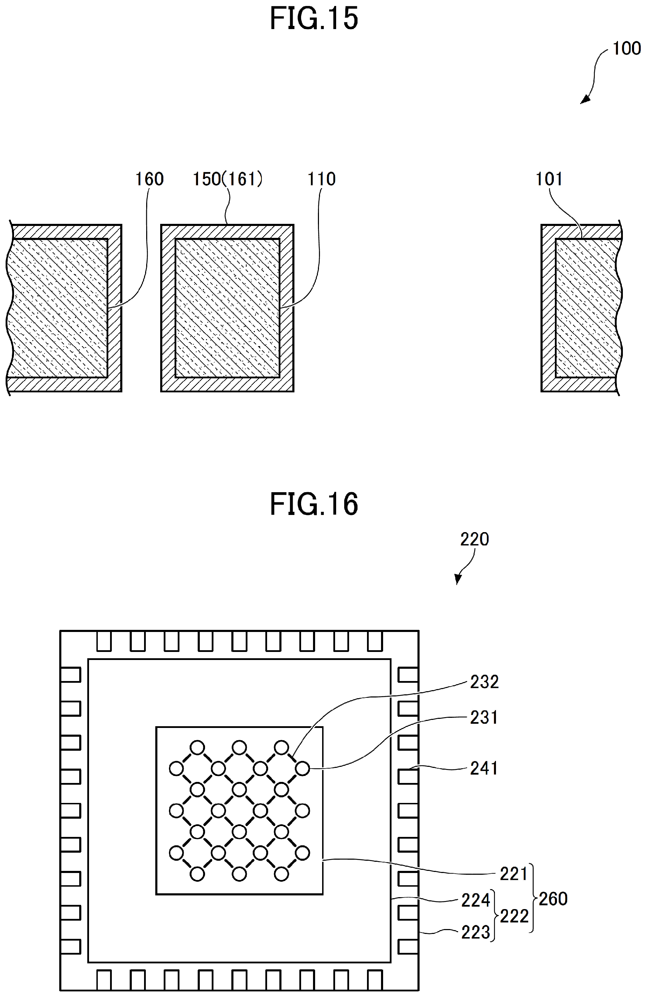

Then, as illustrated in FIG. 15, the mask 50 is removed. Although the conductive layer 164 is formed on the surface of the mask 50 when the conductive layer 164 is formed, it is removed together with the removal of the mask 50. That is, lift-off is performed. In this manner, the first substrate 100 having the conductive layer 161 formed from the conductive layers 162 and 164 can be manufactured.

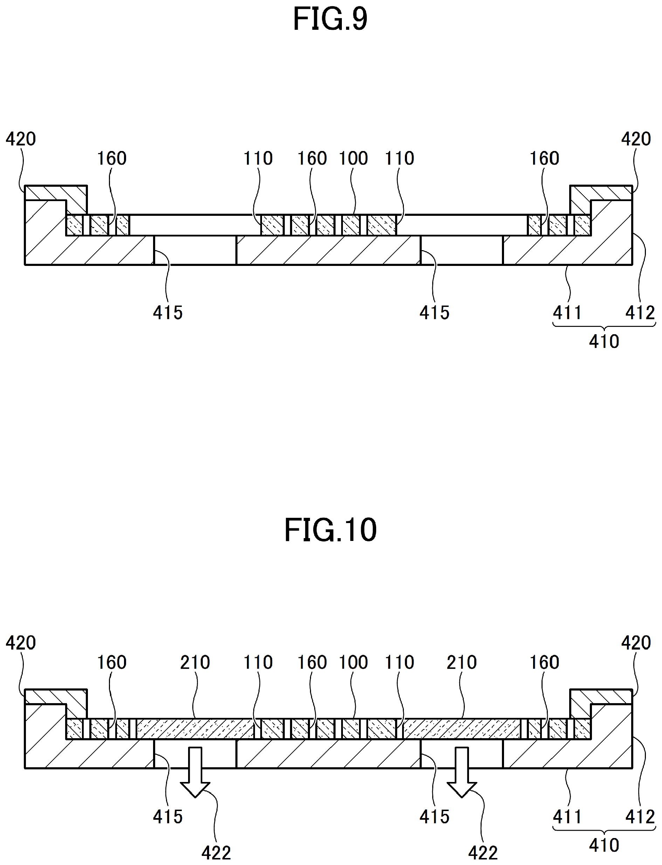

After the first substrate 100 is accommodated in the case 410, the first substrate 100 is fixed to the case 410 by the fixing member 420 as illustrated in FIG. 9. For example, the fixing member 420 is screwed to the wall portion 412 of the case 410.

Next, as illustrated in FIG. 10, the second substrate 210 is placed on the bottom portion 411 inside the opening 110, and vacuum suction 422 is applied to the second substrate 210 through the opening 415. As a result of the vacuum suction 422, the second substrate 210 adheres to the bottom portion 411.

Thereafter, the bonding wire 310 and the conductive ribbon 320 are formed while the second substrate 210 adheres to the bottom portion 411 (see FIG. 3). Then, the vacuum suction 422 of the second substrate 210 is stopped.

Thus, the quantum device 1 can be manufactured.

### (Second Embodiment)

A second embodiment will be described. The second embodiment differs from the first embodiment mainly in the configuration of the second substrate. FIG. 16 is a top view illustrating the second substrate in the second embodiment.

As illustrated in FIG. 16, the quantum device according to the second embodiment has a second substrate 220 instead of the second substrate 210. The second substrate 220 has a second quantum circuit pattern 260 instead of the second quantum circuit pattern 240, and the second quantum circuit pattern 260 has a core portion 221 and a peripheral portion 222 provided around the core portion 221.

The core portion 221 has a plurality of quantum bits 231 and a plurality of couplers 232. The number of the quantum bits 231 in the core portion 221 is, for example, 24. The coupler 232 couples two adjacent quantum bits 231. For example, the quantum bit 231 includes a Josephson junction. The core portion 221 need not have a resonator 233.

The peripheral portion 222 includes a pad region 223 and a peripheral circuit region 224. The second quantum circuit pattern 260 includes a plurality of second signal pads 241 in the pad region 223. The second signal pads 241 are close to the edge of the second substrate 220. The number of the second signal pads 241 may be larger than that of the first embodiment. The second quantum circuit pattern 260 may include quantum circuits such as transmission lines, resonators, filters, and coupling capacitors in the peripheral circuit region 224. For example, the transmission lines may have a configuration of coplanar waveguides.

The number of the first signal pads 141 in the first quantum circuit pattern 140 may be larger than that in the first embodiment according to the number of the second signal pads 241 in the pad region 223. The configuration of the first quantum circuit pattern 140 may be different from that in the first embodiment according to the difference of the second quantum circuit pattern 260 from the second quantum circuit pattern 240. In the first embodiment, for example, the control of the quantum bit 231 is performed through a substrate (not illustrated) provided with control pins, whereas in the second embodiment, the control is performed through the first substrate 100.

Other configurations of the second embodiment are similar to those of the first embodiment, and the same effects as those of the first embodiment can be obtained by the second embodiment.

### (Third Embodiment)

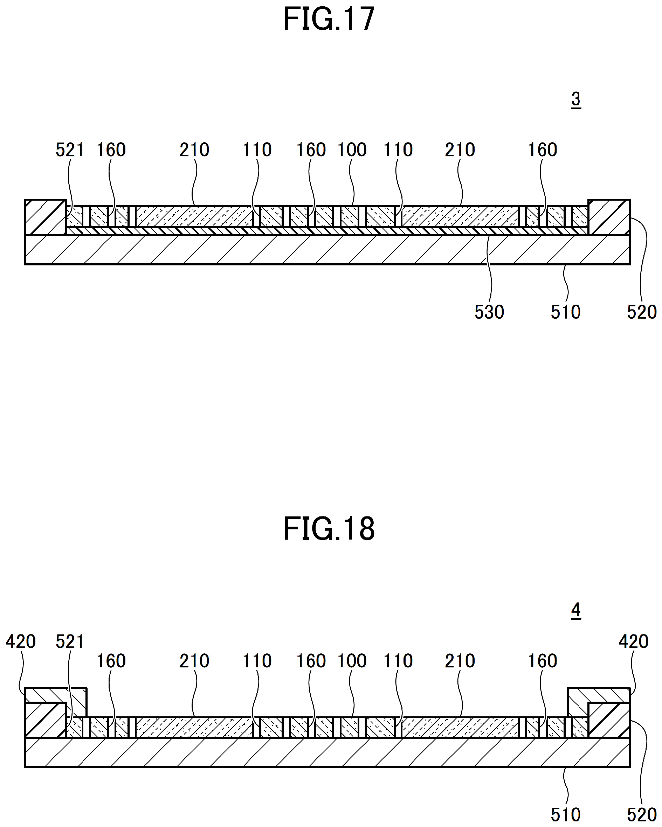

A third embodiment will be described. The third embodiment differs from the first embodiment primarily in that a support member and a printed circuit board (PCB) are mainly provided instead of the case. FIG. 17 is a cross-sectional view illustrating a quantum device according to the third embodiment.

As illustrated in FIG. 17, the quantum device 3 according to the third embodiment has a support member 510 and a printed circuit board 520 instead of the case 410. The printed circuit board 520 is provided on the support member 510, and an opening 521 is formed in the printed circuit board 520. A first substrate 100 and a second substrate 210 are provided on the support member 510 inside the opening 521. The first substrate 100 and the second substrate 210 are adhered to the support member 510 by an adhesive 530. An opening similar to the opening 415 may be formed below the second substrate 210 in the support member 510.

Other configurations of the third embodiment are the same as those of the first embodiment.

According to the third embodiment, as in the first embodiment, it is possible to suppress the reduction of the eigenmode frequency in both the first substrate 100 and the second substrate 210. However, because the adhesive 530 is present in the vicinity of the quantum bit 231, the dielectric loss may be increased as compared with the first embodiment. Further, as compared with the first embodiment, the manufacturing method may be complicated in terms of controlling the amount and position of the adhesive 530. Further, it takes time to solidify the adhesive 530. Therefore, the first embodiment is preferable to the third embodiment.

### (Fourth embodiment)

The fourth embodiment will be described. The fourth embodiment differs from the third embodiment mainly in a mechanism for fixing the first substrate to the support member. FIG. 18 is a cross-sectional view illustrating a quantum device according to the fourth embodiment.

As illustrated in FIG. 18, the quantum device 4 according to the fourth embodiment has a fixing member 420. The fixing member 420 contacts the first substrate 100 and fixes the first substrate 100 to the printed circuit board 520. The fixing member 420 contacts, for example, four corners of the first substrate 100 in plan view. The fixing member 420 is attached to the printed circuit board 520 by, for example, screws. The fixing member 420 includes, for example, oxygen-free copper. The fixing member 420 may be formed of oxygen-free copper. Unlike the quantum device 3, the quantum device 4 does not have the adhesive 530. An opening similar to the opening 415 may be formed below the second substrate 210 of the support member 510.

Other configurations of the fourth embodiment are the same as those of the third embodiment.

The same effects as those of the third embodiment can be obtained by the fourth embodiment. Further, because the quantum device 4 does not have the adhesive 530, dielectric loss can be reduced as compared with the third embodiment.

Although preferred embodiments and the like have been described in detail above, the embodiments and the like described above are not limited, and various modifications and substitutions can be made to the embodiments and the like described above without departing from the scope of the claims.

Hereinafter, various aspects of the present disclosure will be described together as clauses.

### (Clause 1)

A quantum device including:
a first substrate;
a second substrate; and
a third substrate, wherein
the first substrate includes:
   a first opening;
   a second opening; and
   a first quantum circuit pattern which may include a first quantum bit,
the second substrate includes a second quantum circuit pattern including a second quantum bit,
the third substrate includes a third quantum circuit pattern including a third quantum bit,
the second substrate is arranged so as to overlap at least a part of the first opening in plan view,
the third substrate is arranged so as to overlap at least a part of the second opening in plan view,
the first quantum circuit pattern and the second quantum circuit pattern are coupled, and
the first quantum circuit pattern and the third quantum circuit pattern are coupled.

### (Clause 2)

The quantum device according to clause 1, wherein
the second substrate is provided inside the first opening, and
the third substrate is provided inside the second opening.

### (Clause 3)

The quantum device according to clause 1 or 2, further including:
a first conductive member connected to the first quantum circuit pattern and the second quantum circuit pattern; and
a second conductive member connected to the first quantum circuit pattern and the third quantum circuit pattern.

### (Clause 4)

The quantum device according to clause 3, wherein each of the first conductive member and the second conductive member has a length of 400 µm or less.

### (Clause 5)

The quantum device according to clause 3 or 4, wherein
the first quantum circuit pattern includes:
   a first signal pad to which the first conductive member is connected; and
   a second signal pad to which the second conductive member is connected, wherein
the second quantum circuit pattern has a third signal pad to which the first conductive member is connected;
the third quantum circuit pattern has a fourth signal pad to which the second conductive member is connected;
impedance is matched between the first signal pad and the third signal pad; and
impedance is matched between the second signal pad and the fourth signal pad.

### (Clause 6)

The quantum device according to any one of clauses 1 to 5, wherein
the first substrate includes a first ground pattern provided around the first quantum circuit pattern,
the second substrate includes a second ground pattern provided around the second quantum circuit pattern,
the third substrate includes a third ground pattern provided around the third quantum circuit pattern, wherein the quantum device further includes:
   a third conductive member connected to the first ground pattern and the second ground pattern; and
   a fourth conductive member connected to the first ground pattern and the third ground pattern.

### (Clause 7)

The quantum device according to any one of clauses 1 to 6, wherein
a plurality of through-holes are formed in the first substrate, and
the quantum device further includes:
   a conductive layer provided on a wall surface of the through-hole and on both an upper surface and a lower surface of the first substrate.

### (Clause 8)

The quantum device according to clause 7, wherein a plurality of through-holes have an area smaller than an area of the first opening and an area of the second opening.

### (Clause 9)

The quantum device according to clause 2, wherein a distance between a wall surface of the first opening and a wall surface of the second substrate and a distance between a wall surface of the first opening and a wall surface of the third substrate are 100 µm or less.

### (Clause 10)

The quantum device according to any one of clauses 1 to 9, further including:
a case configured to accommodate the first substrate; and
a fixing member configured to contact the first substrate and to fix the first substrate to the case.

### (Clause 11)

The quantum device according to clause 10, wherein the fixing member includes oxygen-free copper.

### (Clause 12)

The quantum device according to clause 10 or 11, wherein a third opening positioned inside a contour of the second substrate in plan view and a fourth opening positioned inside a contour of the third substrate in plan view are formed in the case.

### (Clause 13)

The quantum device according to any one of clauses 1 to 12, wherein the second substrate and the third substrate have a rectangular planar shape with a side length of 15 mm or less.

### (Clause 14)

The quantum device according to any one of clauses 1 to 13, wherein the second substrate and the third substrate do not include through holes.

### (Clause 15)

The quantum device according to any one of clauses 1 to 14, wherein
the second substrate has the second quantum circuit pattern on one surface and does not have a metal film on the other surface, and
the third substrate has the third quantum circuit pattern on one surface and does not have a metal film on the other surface.

### (Clause 16)

The quantum device according to any one of clauses 1 to 15, wherein the first substrate has a silicon substrate.

### (Clause 17)

The quantum device according to any one of clauses 1 to 16, wherein the second substrate and the third substrate each have a silicon substrate or a sapphire substrate.

### (Clause 18)

A method of manufacturing a quantum device, the method including:
preparing a first substrate having a first opening, a second opening, and a first quantum circuit pattern including a first quantum bit;
arranging a second substrate having a second quantum circuit pattern including a second quantum bit so as to overlap at least a part of the first opening in plan view;
arranging a third substrate having a third quantum circuit pattern including a third quantum bit so as to overlap at least a part of the second opening in plan view;
coupling the first quantum circuit pattern and the second quantum circuit pattern; and
coupling the first quantum circuit pattern and the third quantum circuit pattern.

### (Clause 19)

The method of manufacturing the quantum device according to clause 18, the method further including:
providing the second substrate inside the first opening; and
providing the third substrate inside the second opening.

### (Clause 20)

The method of manufacturing the quantum device according to clause 18 or 19, the method further including:
between the preparing of the first substrate and the arranging of the second substrate and the third substrate,
accommodating the first substrate in a case; and
fixing the first substrate to the case by using a fixing member in contact with the first substrate.

### (Clause 21)

The method of manufacturing the quantum device according to clause 20, wherein
a third opening positioned inside a contour of the second substrate in plan view and a fourth opening positioned inside a contour of the third substrate in plan view are formed in the case,
the arranging of the second substrate includes applying suction to the second substrate through the third opening, and
the arranging of the third substrate includes applying suction to the third substrate through the fourth opening.

## Claims

1. A quantum device comprising:
a first substrate;
a second substrate; and
a third substrate, wherein
the first substrate includes:
a first opening;
a second opening; and
a first quantum circuit pattern which may include a first quantum bit,
the second substrate includes a second quantum circuit pattern including a second quantum bit,
the third substrate includes a third quantum circuit pattern including a third quantum bit,
the second substrate is arranged so as to overlap at least a part of the first opening in plan view,
the third substrate is arranged so as to overlap at least a part of the second opening in plan view,
the first quantum circuit pattern and the second quantum circuit pattern are coupled, and
the first quantum circuit pattern and the third quantum circuit pattern are coupled.

2. The quantum device according to claim 1, wherein
the second substrate is provided inside the first opening, and
the third substrate is provided inside the second opening.

3. The quantum device according to claim 1, further comprising:
a first conductive member connected to the first quantum circuit pattern and the second quantum circuit pattern; and
a second conductive member connected to the first quantum circuit pattern and the third quantum circuit pattern.

4. The quantum device according to claim 3, wherein each of the first conductive member and the second conductive member has a length of 400 µm or less.

5. The quantum device according to any one of claims 1 to 4, wherein
the first substrate includes a first ground pattern provided around the first quantum circuit pattern,
the second substrate includes a second ground pattern provided around the second quantum circuit pattern,
the third substrate includes a third ground pattern provided around the third quantum circuit pattern, wherein the quantum device further includes:
a third conductive member connected to the first ground pattern and the second ground pattern; and
a fourth conductive member connected to the first ground pattern and the third ground pattern.

6. The quantum device according to any one of claims 1 to 4, wherein
a plurality of through-holes are formed in the first substrate, and
the quantum device further comprises:
a conductive layer provided on a wall surface of the through-hole and on both an upper surface and a lower surface of the first substrate.

7. The quantum device according to claim 2, wherein a distance between a wall surface of the first opening and a wall surface of the second substrate and a distance between a wall surface of the first opening and a wall surface of the third substrate are 100 µm or less.

8. The quantum device according to any one of claims 1 to 4, further comprising:
a case configured to accommodate the first substrate; and
a fixing member configured to contact the first substrate and to fix the first substrate to the case.

9. The quantum device according to claim 8, wherein the fixing member includes oxygen-free copper.

10. The quantum device according to claim 8, wherein a third opening positioned inside a contour of the second substrate in plan view and a fourth opening positioned inside a contour of the third substrate in plan view are formed in the case.

11. A method of manufacturing a quantum device, the method comprising:
preparing a first substrate having a first opening, a second opening, and a first quantum circuit pattern which may include a first quantum bit;
arranging a second substrate having a second quantum circuit pattern including a second quantum bit so as to overlap at least a part of the first opening in plan view;
arranging a third substrate having a third quantum circuit pattern including a third quantum bit so as to overlap at least a part of the second opening in plan view;
coupling the first quantum circuit pattern and the second quantum circuit pattern; and
coupling the first quantum circuit pattern and the third quantum circuit pattern.

12. The method of manufacturing the quantum device according to claim 11, the method further comprising:
providing the second substrate inside the first opening; and
providing the third substrate inside the second opening.

13. The method of manufacturing the quantum device according to claim 11 or 12, the method further comprising:
between the preparing of the first substrate and the arranging of the second substrate and the third substrate,
accommodating the first substrate in a case; and
fixing the first substrate to the case by using a fixing member in contact with the first substrate.

14. The method of manufacturing the quantum device according to claim 13, wherein
a third opening positioned inside a contour of the second substrate in plan view and a fourth opening positioned inside a contour of the third substrate in plan view are formed in the case,
the arranging of the second substrate includes applying suction to the second substrate through the third opening, and
the arranging of the third substrate includes applying suction to the third substrate through the fourth opening.
